# EUROPEAN PATENT SPECIFICATION

(11) **EP 2 485 265 B1**
(45) Date of publication and mention of the grant of the patent: **26.12.2018**
(21) Application number: 10820391.0
(22) Date of filing: 17.09.2010
(51) Int. Cl.: H01L 31/04

(54) **PHOTOELECTRIC CONVERSION DEVICE**
PHOTOELEKTRISCHE UMWANDLUNGSVORRICHTUNG
DISPOSITIF DE CONVERSION PHOTOÉLECTRIQUE

(30) Priority: 29.09.2009 JP 2009224268
(43) Date of publication of application: 08.08.2012
(73) Proprietor: Kyocera Corporation, Kyoto-shi Kyoto 612-8501 (JP)
(72) Inventor: KAMADA Rui, Higashiomi-shi Shiga 527-8555 (JP); NAKAZAWA Shuji, Higashiomi-shi Shiga 527-8555 (JP); HORIUCHI Nobuyuki, Higashiomi-shi Shiga 527-8555 (JP); KUBO Shintaro, Higashiomi-shi Shiga 527-8555 (JP); MIYAMICHI Yusuke, Higashiomi-shi Shiga 527-8555 (JP)
(74) Representative: Viering, Jentschura & Partner mbB Patent- und Rechtsanwälte
(86) International application number: PCT/JP2010/066201
(87) International publication number: WO 2011/040272

(56) References cited:
- JP-A- 2001 274 176
- JP-A- 2008 243 983
- JP-A- 2009 105 130
- C. A. KAUFMANN ET AL.: "Loew temperature growth of Cu(In,Ga)Se2", 23RD EUROPEAN PHOTOVOLTAIC SOLAR ENERGY CONFERENCE, EU PVSEC ; PROCEEDINGS OF THE INTERNATIONAL CONFERENCE, HELD IN VALENCIA, SPAIN, 1 - 5 SEPTEMBER 2008, WIP-RENEWABLE ENERGIES, D, 1 September 2008 (2008-09-01), XP040529368, ISBN: 978-3-936338-24-9
- T. NAKADA ET AL.: "CIGS Thin Film Solar Cells on Flexible Foils", 24TH EUROPEAN PHOTOVOLTAIC SOLAR ENERGY CONFERENCE AND EXHIBITION ; CONFERENCE 21 - 25 SEPTEMBER 2009, EXHIBITION 21 - 24 SEPTEMBER 2009, HAMBURG ; PROCEEDINGS ; EU PVSEC, WIP-RENE, 21 September 2009 (2009-09-21), XP040530377, ISBN: 978-3-936338-25-6
- TAKESHI YAGIOKA ET AL: "Cd-Free Flexible Cu(In,Ga)Se2 Thin Film Solar Cells with ZnS(O,OH) Buffer Layers on Ti Foils", APPLIED PHYSICS EXPRESS, JAPAN SOCIETY OF APPLIED PHYSICS; JP, JP, vol. 2, no. 7, 1 July 2009 (2009-07-01), pages 72201-1, XP001551853, ISSN: 1882-0778, DOI: 10.1143/APEX.2.072201 [retrieved on 2009-06-19]

## Description

### Technical Field

The present invention relates to a photoelectric conversion device according to the preamble of claim 1.

### Background Art

As solar batteries, there are photoelectric conversion devices including a light-absorbing layer composed of a group I-III-VI compound semiconductor. The group I-III-VI compound semiconductor is a chalcopyrite-based compound semiconductor made of CIGS or the like. For example, in this photoelectric conversion device, a backside electrode composed of Mo or the like is formed as a first electrode layer on a substrate made of soda-lime glass, and a light-absorbing layer composed of a group I-III-VI compound semiconductor is formed on this first electrode layer. Further, a buffer layer composed of ZnS, CdS or the like and a transparent second electrode layer composed of ZnO or the like are layered in this order on the light-absorbing layer.

It is important to increase the crystal grain size of a semiconductor that constitutes a light-absorbing layer for enhancing photoelectric conversion efficiency of such a photoelectric conversion device. Incidentally, as the method of manufacturing a light-absorbing layer, there is disclosed the technology of baking a precursor (also referred to as layered precursor) including different layers composed of a plurality of elements, which are used for forming the light-absorbing layer, to thereby form a light-absorbing layer having large crystal grains (Japanese Patent Application Laid-Open No. 10-135495 (1998)). Further, there is disclosed the technology in which a first thin film containing a group III element and a group VI element is formed, and then copper and a group VI element are supplied onto the first thin film, to thereby form a light-absorbing layer (Japanese Patent Application Laid-Open No. 2000-156517).

A photoelectric conversion device according to the initially-mentioned type is disclosed in C.A. KAUFMANN ET AL. : "Low temperature growth of Cu(In, Ga)Se2", 23RD EUROPEAN PHOTOVOLTAIC SOLAR ENERGY CONFERENCE, EU PVSEC ; PROCEEDINGS OF THE INTERNATIONAL CONFERENCE, HELD IN VALENCIA, SPAIN, 1-5 SEPTEMBER 2008, WIP-RENEWABLE ENERGIES, D, 1 September 2008 (2008-09-01), XP040529368, ISBN: 978-3-936338-24-9.

### Summary of the Invention

### Problem to be Solved by the Invention

Unfortunately, in a case where the crystal grain size is large in a light-absorbing layer, the adhesion of the light-absorbing layer to an electrode layer decreases, and accordingly the light-absorbing layer is apt to peel off from the electrode layer.

Therefore, a photoelectric conversion device that has high adhesion between a light-absorbing layer and an electrode layer as well as high photoelectric conversion efficiency is desired.

### Means to Solve the Problem

The present invention provides a photoelectric conversion device according to claim 1. Further embodiments of the present invention are described in the dependent claims.

### Effects of the Invention

According to the above-mentioned photoelectric conversion device, it is possible to provide a photoelectric conversion device that has high adhesion between a light-absorbing layer and an electrode layer as well as high photoelectric conversion efficiency.

### Brief Description of Drawings

FIG. 1 is a cross-sectional view illustrating a photoelectric conversion module according to a first embodiment.
FIG. 2 is a cross-sectional view illustrating a photoelectric conversion module according to a second embodiment.
FIG. 3 is a perspective view of the photoelectric conversion module shown in FIG. 2 .
FIG. 4 is a figure illustrating a peel-off state of a light-absorbing layer in Comparative Example 1.
FIG. 5 is a figure illustrating crystal grains of a light-absorbing layer according to Example.
FIG. 6 is a figure illustrating the condition of voids of the light-absorbing layer according to Example.

### Embodiments for Carrying Out the Invention

Hereinafter, photoelectric conversion devices according to embodiments of the present invention are described in detail with reference to the drawings.

### <(1) Photoelectric conversion device according to First Embodiment>

### <(1-1) Configuration of photoelectric conversion device>

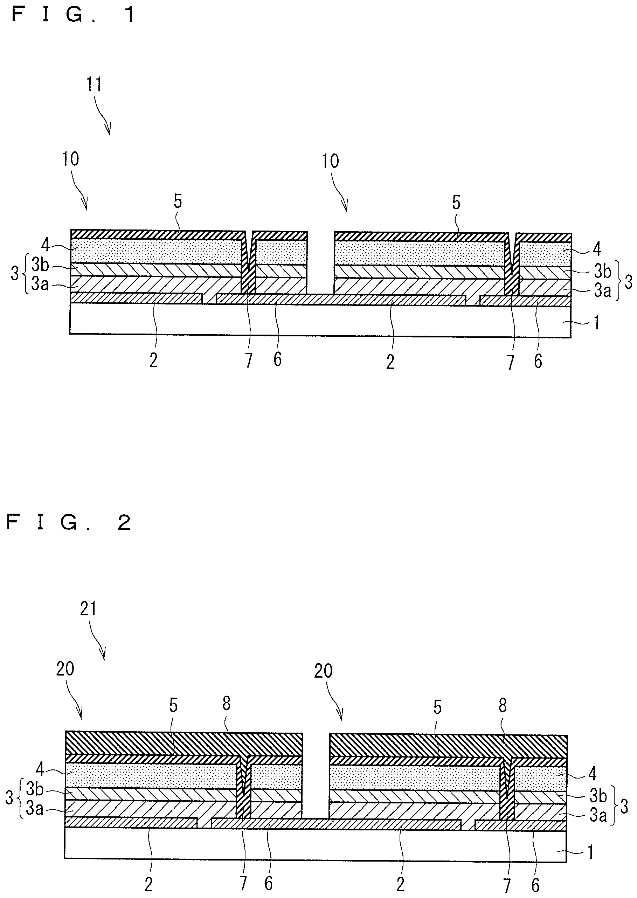

FIG. 1 is a view schematically showing a cross section of a photoelectric conversion module 11 according to a first embodiment. The photoelectric conversion module 11 includes a plurality of photoelectric conversion devices 10, and the plurality of photoelectric conversion devices 10 are arranged in a planar manner and are electrically connected in series with each other. As shown in FIG. 1, the photoelectric conversion device 10 includes a substrate 1, a first electrode layer 2, a light-absorbing layer 3, a buffer layer 4, a second electrode layer 5, a third electrode layer 6 and a connection conductor 7. Specifically, the first and third electrode layers 2 and 6 are provided on the substrate 1, the light-absorbing layer 3 as a semiconductor layer is provided on the first and third electrode layers 2 and 6, the buffer layer 4 is provided on the light-absorbing layer 3, and the second electrode layer 5 is further provided on the buffer layer 4.

The first electrode layer 2 and the third electrode layer 6 are arranged in a planar manner between the light-absorbing layer 3 and the substrate 1 and are spaced from each other. The connection conductor 7 is provided so as to separate the light-absorbing layer 3 and the buffer layer 4 and electrically connects the second electrode layer 5 to the third electrode layer 6. The third electrode layer 6 is formed integrally with the first electrode layer 2 of the neighboring photoelectric conversion device 10, which is a portion extended from the first electrode layer 2. With this configuration, the neighboring photoelectric conversion devices 10 are electrically connected in series with each other. In the photoelectric conversion device 10, the light-absorbing layer 3 and the buffer layer 4 sandwiched between the first electrode layer 2 and the second electrode layer 5 perform photoelectric conversion.

The substrate 1 serves to support the plurality of photoelectric conversion devices 10. Examples of the material used for the substrate 1 include glass, ceramics, resins, and metals. Examples of the material used for the first electrode layer 2 and the third electrode layer 6 include conductors of molybdenum, aluminium, titanium and gold. The first electrode layer 2 and the third electrode layer 6 are formed on the substrate 1 by, for example, a sputtering method or a vapor deposition process.

The light-absorbing layer 3 contains a group I-III-VI compound semiconductor, and includes a first region 3a located on the first electrode layer 2 side and a second region 3b that is farther apart from the first electrode layer 2 than the first region 3a and is located on the side opposite to the first electrode layer 2. The average grain diameter of crystal grains in the second region 3b is larger than the average grain diameter of crystal grains in the first region 3a. In this case, the first region 3a corresponds to a portion extending from the center of the light-absorbing layer 3 in the thickness direction to the first electrode layer 2, while the second region 3b corresponds to a portion extending from the center of the light-absorbing layer 3 in the thickness direction to the buffer layer 4.

With the above-mentioned configuration, a large number of crystal grains having a relatively small grain diameter exist in the first region 3a, and accordingly those individual crystal grains can adhere well to the first and third electrode layers 2 and 6. This improves the adhesion of the entirety of the light-absorbing layer 3 to the first and third electrode layers 2 and 6. As a result, even when a stress is generated between the light-absorbing layer 3 and the first and third electrode layers 2 and 6 due to thermal expansion, external force or the like, the light-absorbing layer 3 is resistant to peel-off from the first and third electrode layers 2 and 6. Further, the grain diameter of the crystal grains is relatively large and crystallinity is high in the second region 3b, leading to improvements in photoelectric conversion efficiency in the photoelectric conversion device 10.

The group I-III-VI compound semiconductor means a semiconductor containing a compound of a group I-B element (also referred to as a group 11 element), a group III-B element (also referred to as a group 13 element) and a group VI-B element (also referred to as a group 16 element), has a chalcopyrite structure, and is referred to as a chalcopyrite-based compound semiconductor (also referred to as a CIS-based compound semiconductor). Examples of the group I-III-VI compound semiconductor include Cu(In, Ga)Se₂ (also referred to as CIGS), Cu(In, Ga)(Se, S)₂ (also referred to as CIGSS) and CuInS₂ (also referred to as CIS). Note that Cu(In, Ga)Se₂ is a compound mainly comprised of Cu, In, Ga and Se. Further, Cu(In, Ga)(Se, S)₂ is a compound mainly comprised of Cu, In, Ga, Se and S.

In the light-absorbing layer 3, the average grain diameter of crystal grains in the second region 3b is larger than the average grain diameter of crystal grains in the first region 3a. The above-mentioned light-absorbing layer 3 is not limited to one obtained by layering two light-absorbing layers having different average grain diameters. That is, it suffices that in the light-absorbing layer 3, the average grain diameter of crystal grains in the second region 3b on the buffer layer 4 side is larger than the average grain diameter of crystal grains in the first region 3a on the first electrode layer 2 side. Therefore, three or more light-absorbing layers having different average grain diameters may be layered such that the average grain diameters gradually change. Alternatively, the average grain diameter of crystal grains progressively changes in one light-absorbing layer. In a case where the grain diameter shows a tendency to increase gradually or in steps from the first electrode layer 2 side toward the buffer layer 4 side in the light-absorbing layer 3 as described above, a stress is hard to be concentrated in the light-absorbing layer 3. As to the tendency in which the grain diameter increases gradually or in steps from the first electrode layer 2 side toward the buffer layer 4 side in the light-absorbing layer 3, it suffices that a change of the grain diameter in the direction from the first electrode layer 2 side toward the buffer layer 4 side has a tendency to increase on average, which may increase or decrease slightly.

From the perspective of enhancing the photoelectric conversion efficiency in the photoelectric conversion device 10, the light-absorbing layer 3 may have a thickness of 1.5 µm or more and 2.0 µm or less. Further, the average grain diameter of crystal grains in the first region 3a of the light-absorbing layer 3 may be set to 0.05 times or more and 0.5 times or less of the average grain diameter of crystal grains in the second region 3b. This enhances the adhesion between the light-absorbing layer 3 and the first and third electrode layers 2 and 6 and also enhances the photoelectric conversion efficiency in the photoelectric conversion device 10. Further, the average grain diameter of crystal grains in the first region 3a may be set to 0.1 µm or more and 0.5 µm or less, while the average grain diameter of crystal grains in the second region 3b may be set to 1 µm or more and 2 µm or less.

Further, the average grain diameter of crystal grains of the first region 3a in the range of up to 0.2 µm from the interface between the first electrode layer 2 and the first region 3a (hereinafter, referred to as a region close to the first electrode layer) may be smaller than the average grain diameter of crystal grains of the second region 3b in the range of up to 0.5 µm from the interface between the second region 3b and the buffer layer 4 (also referred to as a region close to the buffer layer). In this case, the average grain diameter of crystal grains in the region close to the first electrode layer can be set to 0.05 times or more and 0.3 times or less of the average grain diameter of crystal grains in the region close to the buffer layer. In particular, the grain diameter of crystal grains in the portion in contact with the first and third electrode layers 2 and 6 is varied from the grain diameter of crystal grains in the portion in contact with the buffer layer 4 in the light-absorbing layer 3 as described above, which enhances the adhesion between the light-absorbing layer 3 and the first and third electrode layers 2 and 6 as well as the photoelectric conversion efficiency in the photoelectric conversion device 10.

The buffer layer 4 forms a heterojunction with the light-absorbing layer 3. The light-absorbing layer 3 and the buffer layer 4 may be semiconductor layers having conductivity types different from each other and, for example, in a case where the light-absorbing layer 3 is a p-type semiconductor, the buffer layer 4 may be an n-type semiconductor. From the perspective of reducing current leakage, the buffer layer 4 may be a layer having a resistivity of 1 Ω·cm or more. Examples of the material used for the buffer layer 4 include CdS, ZnS, ZnO, In₂Se₃, In(OH, S), (Zn, In)(Se, OH) and (Zn, Mg)O. The buffer layer 4 is formed by, for example, a chemical bath deposition (CBD) method. Note that In(OH, S) is a compound mainly comprised of In, OH and S. (Zn, In)(Se, OH) is a compound mainly comprised of Zn, In, Se and OH. (Zn, Mg)O is a compound mainly comprised of Zn, Mg and O. From the perspective of enhancing the light absorption efficiency in the light-absorbing layer 3, the buffer layer 4 may be light transmissive for the wavelength region of the light absorbed by the light-absorbing layer 3.

Further, the buffer layer 4 may have a thickness of 10 nm or more and 200 nm or less, and may have a thickness of 100 nm or more. This effectively reduces the degradation of photoelectric conversion efficiency in the photoelectric conversion device 10 also under the conditions of high temperature and high humidity.

The second electrode layer 5 is a transparent conductive film mainly comprised of a material such as ITO or ZnO and has a thickness of 0.05 µm or more and 3.0 µm or less. The second electrode layer 5 is formed by a sputtering method, a vapor deposition process, a chemical vapor deposition (CVD) method or the like. The second electrode layer 5 is a layer having an electric resistivity lower than that of the buffer layer 4 and serves to extract the charges generated in the light-absorbing layer 3. From the perspective of extracting the charges well, the second electrode layer 5 may have a resistivity of less than 1Ω·cm and a sheet resistance of 50 Ω/□ or less.

From the perspective of enhancing the light absorption efficiency in the light-absorbing layer 3, the second electrode layer 5 may be one having light transmittance for the wavelength region of the light absorbed in the light-absorbing layer 3. From the perspective of enhancing light transmittance, a loss reduction effect, and a light scattering effect in light reflection, and further from the perspective of good transmission of the current generated by photoelectric conversion, the second electrode layer 5 may have a thickness of 0.05 µm or more and 0.5 µm or less. In addition, from the perspective of reducing a light reflection loss at the interface between the second electrode layer 5 and the buffer layer 4, the second electrode layer 5 and the buffer layer 4 may have an equal refractive index.

In the photoelectric conversion device 10, the portion including the buffer layer 4 and the second electrode layer 5, that is, the portion sandwiched between the light-absorbing layer 3 and a collector electrode 8 may include a group III-VI compound as a main component. The fact that a group III-VI compound is included as a main component indicates that a group III-VI compound (in a case of a plurality of types of group III-VI compounds, the total thereof) to the compounds constituting the portion including the buffer layer 4 and the second electrode layer 5 is 50 mol% or more, and further, 80 mol% or more. Further, from the perspective of improving the moisture resistance of the photoelectric conversion device 10, a Zn element to the metal elements constituting the portion including the buffer layer 4 and the second electrode layer 5 may be 50 atomic% or less, and more preferably, 20 atomic% or less.

A plurality of photoelectric conversion devices 10 each having the above-mentioned configuration are arranged and are electrically connected to each other, whereby the photoelectric conversion module 11 is formed. In this case, as shown in FIG. 1, the photoelectric conversion device 10 includes the first electrode layer 2 and the third electrode layer 6 provided to be spaced from the first electrode layer 2 between the light-absorbing layer 3 and the substrate 1, so that the neighboring photoelectric conversion devices 10 are electrically connected in series with each other with ease. Further, the second electrode layer 5 and the third electrode layer 6 are electrically connected to each other by the connection conductor 7 that separates the light-absorbing layer 3 and the buffer layer 4.

The connection conductor 7 is mainly comprised of a material having conductivity and may be formed in the step of forming the second electrode layer 5. That is, the connection conductor 7 may be formed integrally with the second electrode layer 5. This simplifies the steps of forming the second electrode layer 5 and the connection conductor 7 and enhances the electrical connection reliability between the connection conductor 7 and the second electrode layer 5.

With the above-mentioned configuration, photoelectric conversion is performed well by the light-absorbing layer 3 of each of the neighboring photoelectric conversion devices 10, and a current is extracted by electrical series connection of a plurality of photoelectric conversion devices 10 by the connection conductor 7.

### <(1-2) Method of manufacturing light-absorbing layer and detailed configuration thereof>

The light-absorbing layer 3 is manufactured by, for example, the manufacturing method in which Step A1 and Step A2 below are performed in this order (referred to as a manufacturing method A). In Step A1, first, the first and third electrode layers 2 and 6 are provided on one main surface of the substrate 1, and then a group I-B element such as Cu, group III-B elements such as In and/or Ga, and group VI-B elements such as Se and/or S are supplied by, for example, vapor deposition, to thereby form the first region 3a of the light-absorbing layer 3. The temperature of the substrate 1 when the first region 3a is formed in Step A1 is set to, for example, 300°C or higher and 500°C or lower. In Step A2, then, the group I-B element, the group III-B element and the group VI-B element are supplied while the first region 3a is being heated by irradiating the upper surface of the first region 3a with light by a lamp or laser, to thereby form the second region 3b. The temperature of the substrate 1 when the second region 3b is formed in Step A2 is higher than the temperature of the substrate 1 in Step A1 and, for example, is set to 500°C or higher and 600°C or lower. The light-absorbing layer 3 having an average grain diameter of crystal grains, which is different in steps, is formed by the manufacturing method as described above.

Further, the light-absorbing layer 3 can be manufactured also by the manufacturing method (also referred to as a manufacturing method B) below. In the manufacturing method B, first, the first and third electrode layers 2 and 6 are provided on one main surface of the substrate 1, and then the group I-B element, the group III-B element and the group VI-B element are supplied by, for example, vapor deposition. On this occasion, the surface of the light-absorbing layer during the generation (also referred to as an intermediate of the light-absorbing layer) is irradiated with light by a lamp or laser, whereby the intermediate of the light-absorbing layer is heated. Then, the feedstocks described above are supplied while increasing the temperature, to thereby form the light-absorbing layer 3. The temperature of the substrate 1 when the light-absorbing layer 3 is formed in this step is set to, for example, 300°C or higher and 500°C or lower. The light-absorbing layer 3 having an average grain diameter of crystal grains, which is different in a gradual manner from one main surface to the other main surface, is formed by the manufacturing method as described above.

Further, it is possible to manufacture the light-absorbing layer 3 by the manufacturing method in which Step C1, Step C2 and Step C3 below are performed in this order (referred to as a manufacturing method C). In Step C1, first, the first and third electrode layers 2 and 6 are provided on one main surface of the substrate 1, and then, the group I-B element and the group III-B element are supplied, to thereby form a precursor by sputtering or the like. In Step C2, next, the precursor is heated in the atmosphere including the group VI-B element, to thereby form the first region 3a of the light-absorbing layer 3. The temperature of the substrate 1 when the first region 3a is formed in Step C2 is set to, for example, 300°C or higher and 500°C or lower. In Step C3, then, the group I-B element, the group III-B element and the group VI-B element are supplied while the first region 3a is being heated by irradiating the upper surface of the first region 3a with light by a lamp or laser, to thereby form the second region 3b by a sputtering method or the like. The temperature of the substrate 1 when the second region 3b is formed in Step C3 is set to, for example, 500°C or higher and 600°C or lower. The light-absorbing layer 3 having an average grain diameter of crystal grains, which is different in steps, is formed by the manufacturing method as described above.

Note that in Step C2 above, the first region 3a is formed also by vapor-depositing Se onto the surface of the precursor and then heating the precursor under an inert atmosphere of nitrogen, argon or the like.

Further, it is possible to manufacture the light-absorbing layer 3 by the manufacturing method in which Step D1, Step D2, Step D3, Step D4 and Step D5 below are performed in this order (also referred to as a manufacturing method D). In Step D1, first, the first and third electrode layers 2 and 6 are provided on one main surface of the substrate 1, and then a solution containing the group I-B element, the group III-B element and the group VI-B element as feedstocks (also referred to as a stock solution) is applied thereonto, to thereby form a first precursor. In Step D2, next, the first precursor is calcined (heat-treated), to thereby form a calcined first precursor. The temperature of the substrate 1 when the calcined first precursor is formed in Step D2 is set to, for example, 200°C or higher and 300°C or lower. In Step D3, then, the calcined first precursor is heated in an atmosphere including the group VI-B element or in an inert atmosphere of nitrogen, argon or the like, to thereby form the first region 3a of the light-absorbing layer 3. The temperature of the substrate 1 when the first region 3a is formed in Step D3 is set to, for example, 300°C or higher and 500°C or lower. In Step D4, then, the stock solution containing the group I-B element, the group III-B element and the group VI-B element is applied onto the first region 3a, to thereby form a second precursor. In Step D5, next, the second precursor is heated in an atmosphere including the group VI-B element or in an inert atmosphere of nitrogen, argon or the like, to thereby form the second region 3b. The temperature of the substrate 1 when the second region 3b is formed in Step D5 is set to, for example, 300°C or higher and 600°C or lower. The light-absorbing layer 3 having an average grain diameter of crystal grains, which is different in steps, is formed by the manufacturing method as described above.

Note that in any manufacturing method of the manufacturing method A, manufacturing method B, manufacturing method C and manufacturing method D, the first region 3a is formed at a relatively low temperature, while the second region 3b is formed at a temperature higher than that of the first region 3a. This allows the first region 3a to be kept once at a relatively low temperature, and thus the growth of crystal grains in the first region 3a is stabilized to some extent. As a result, the crystal grains can be suppressed from growing significantly in the first region 3a even when heat treatment is performed at a relatively high temperature thereafter.

In this case, from the perspective of facilitating the manufacturing step for the light-absorbing layer 3, there may be employed the manufacturing method including the step of forming a precursor by application of the stock solution containing the group I-B element, the group III-B element and the group VI-B element, similarly to the manufacturing method D.

As the stock solution used in such application, there may be used, for example, one containing a metal element belonging to a group I-B element (referred to as a group I-B metal), a metal element belonging to a group III-B element (referred to as III-B metal), an organic compound containing chalcogen element and a Lewis base organic solvent. Specifically, for example, a group I-B metal and a group III-B metal are dissolved well in a solvent containing an organic compound containing a chalcogen element and a Lewis base organic solvent (also referred to as a mixed solvent S), to thereby produce a stock solution in which the concentration of the total of the group I-B metal and the group III-B metal is 6 wt% or higher. The mixed solvent S is used in this case, and thus a remarkably higher-concentration stock solution can be obtained compared with the case where a stock solution is produced by dissolving a group I-B metal and a group III-B metal in only any one of an organic compound containing a chalcogen element and a Lewis base organic solvent. Accordingly, a film-like precursor is formed with the use of this stock solution, to thereby obtain an excellent precursor which has a relatively large thickness only by one application. As a result, it is possible to manufacture the light-absorbing layer 3 having a desired thickness well and easily.

The organic compound containing a chalcogen element refers to an organic compound containing a chalcogen element. The chalcogen elements refer to sulfur, selenium and tellurium among the group VI-B elements.

In a case where the chalcogen element is S, examples of the organic compound containing a chalcogen element include thiol, sulfid, disulfid, thiophene, sulfoxide, sulfone, thioketone, sulfonic acid, sulfonate ester and sulfonic acid amide. From the perspective of forming a complex with a metal to produce a metal solution well, the organic compound containing a chalcogen element may be thiol, sulfid, disulfid or the like. In particular, from the perspective of enhancing coatability, a compound including a phenyl group may be used as the organic compound containing a chalcogen element. Examples of the compound including a phenyl group include thiophenol, diphenyl sulfide and derivatives thereof.

In a case where the chalcogen element is Se, examples of the organic compound containing a chalcogen element include selenol, selenide, diselenide, selenoxide and selenone. From the perspective of producing a metal solution well by the formation of a complex with a metal, selenol, selenide, diselenide or the like may be used as the organic compound containing a chalcogen element. In particular, from the perspective of enhancing coatability, a compound including a phenyl group is preferably employed. Examples of the compound including a phenyl group include phenylselenol, phenyl selenide, diphenyl diselenide and derivatives thereof.

In a case where the chalcogen element is Te, examples of the organic compound containing a chalcogen element include tellurol, telluride and ditelluride.

The Lewis base organic solvent is an organic compound having a functional group which includes a lone pair. At least one of a functional group containing a group V-B element (also referred to as a group 15 element) including a lone pair and a functional group containing a group VI-B element including a lone pair can be used as the above-mentioned functional group. Examples of the Lewis base organic solvent include pyridine, aniline, triphenyl phosphine and derivatives thereof. In particular, from the perspective of enhancing coatability, a boiling point may be 100°C or higher.

From the perspective of handling, a solution that is liquid at a room temperature can be used as the mixed solvent S. The weight of the organic compound containing a chalcogen element in the mixed solvent S may be 0.1 times or more and 10 times or less of the weight of the Lewis base organic solvent. Accordingly, the chemical bonding of a group I-B metal and an organic compound containing a chalcogen element, the chemical bonding of a group III-B metal and an organic compound containing a chalcogen element, and the chemical bonding of an organic compound containing a chalcogen element and the Lewis base organic solvent occur well, to thereby obtain a stock solution having a high concentration of the total of a group I-B metal and a group III-B metal.

Examples of the method of dissolving a group I-B metal and a group III-B metal in the mixed solvent S to produce a stock solution include the method of directly dissolving a group I-B metal and a group III-B metal in the mixed solvent S. At least one of a group I-B metal and a group III-B metal may be a metal salt. From the perspective of reducing the inclusion of impurities other than the components of a group I-III-VI compound semiconductor in the light-absorbing layer 3, a group I-B metal and a group III-B metal may be directly dissolved into the mixed solvent S. Note that directly dissolving a group I-B metal and a group III-B metal into the mixed solvent S refers to directly incorporating the base metal of an elemental metal or the base metal of an alloy into the mixed solvent S to be dissolved. This omits the step of changing the base metal of an elemental metal or the base metal of an alloy into the other compound (for example, metal salt such as a chloride) once and then dissolving the resultant into a solvent. As a result, the step of producing a stock solution is simplified, and the elements other than the essential constituent elements are less likely to be incorporated into the light-absorbing layer 3, which enhances the purity of the light-absorbing layer 3.

The group I-B metals include Cu and/or Ag. The group I-B metal contained in the stock solution may be one type of metal element or two or more types of metal elements. In a case where the stock solution contains two or more types of group I-B metals, the method of dissolving the mixture containing two or more types of group I-B metals into the mixed solvent S at one time may be employed as the method of dissolving group I-B metals into the mixed solvent S to produce a stock solution. Alternatively, there may be employed the method of respectively dissolving group I-B metals into the mixed solvent S and then mixing those.

The group III-B metals include Ga and/or In. The group III-B metal contained in the stock solution may be one type of metal element or two or more types of metal elements. In a case where two or more types of group III-B metals are contained in the stock solution, the method of dissolving the mixture containing two or more types of group III-B metals into the mixed solvent S at one time may be employed as the method of dissolving group III-B metals into the mixed solvent S to produce a stock solution. Alternatively, there may be employed the method of respectively dissolving group III-B metals into the mixed solvent S and then mixing those.

Incidentally, examples of the method of forming the light-absorbing layer 3 with the use of the above-mentioned stock solution include the method below. For example, the first and third electrode layers 2 and 6 are provided on one main surface of the substrate 1, and then the stock solution is applied thereonto, to thereby form a film-like precursor. Then, this precursor is heat-treated, and accordingly a group I-B metal, a group III-B metal and a chalcogen element of the organic compound containing a chalcogen element react with each other to form a semiconductor layer (for example, CIGS) comprised of a compound of a group I-B metal, a group III-B metal and a chalcogen element.

Note that the organic compound containing a chalcogen element is mixed with the Lewis base organic solvent to form the mixed solvent S. The organic compound containing a chalcogen element has the function of dissolving a group I-B metal and a group III-B metal as one component of this mixed solvent S and the function of reacting with a group I-B metal and a group III-B metal by heat treatment to form a compound semiconductor. The chalcogen element contained in this organic compound containing a chalcogen element decrease due to, for example, vaporization during the heat treatment in some cases. In another case, a large amount of chalcogen elements is supplied for obtaining a desired composition ratio of a group I-III-VI compound semiconductor. Examples of the method for supplementing the decreasing chalcogen elements or for supplementing chalcogen elements for the purpose of obtaining a desired composition ratio include the method of separately dissolving chalcogen elements into a stock solution and the method of supplying chalcogen elements by gaseous hydrogen sulfide, gaseous hydrogen selenide or Se vapor.

The stock solution is applied by the method such as spin coating, screen printing, dipping, spraying or die coating, and then is dried, resulting in a film-like precursor. Drying can be performed under a reducing atmosphere, and the temperature during drying is set to, for example, 50°C or higher and 300°C or lower. Then, the precursor is heat-treated, to thereby manufacture the light-absorbing layer 3 having a thickness of 1.0 µm or more and 2.5 µm or less.

Further, in the light-absorbing layer 3, the ratio of voids (also referred to as a void volume) in the first region 3a is larger than the void volume in the second region 3b. Accordingly, even when a stress is generated in the connecting portion of the light-absorbing layer 3 and the first electrode layer 2, the stress is absorbed by the voids in the first region 3a. This enhances the reliability of the connection between the light-absorbing layer 3 and the first electrode layer 2. Note that the cases where the void volume in the first region 3a is larger than the void volume in the second region 3b also include the case where voids are not generated in the second region 3b but the voids are generated in the first region 3a. The void volume in the first region 3a may be 10% or more and 80% or less, while the void volume in the second region 3b may be 50% or less, and further, 25% or less of the void volume in the first region 3a. This enhances the reliability of the connection between the light-absorbing layer 3 and the first electrode layer 2 as well as the photoelectric conversion efficiency in the photoelectric conversion device 10.

The void volumes of the first region 3a and the second region 3b are obtained by, for example, the area ratio of the portions of voids in a cross section perpendicular to the first electrode layer 2. Specifically, the portions of voids of an image in which the cross section of the first region 3a is taken are colored black and then subjected to binarization, to thereby obtain the void volume of the first region 3a by image processing. The void volume of the second region 3b is also obtained by a similar method.

Further, as to the light-absorbing layer 3, the compound semiconductor constituting the light-absorbing layer 3 may contain Cu(In, Ga)(Se, S)₂. In this case, the ratio of an amount of substance (also referred to as molar ratio) represented by In/(In+Ga) in the first region 3a may be smaller than the ratio of an amount of substance of indium (In) to the total of an amount of substance of In and an amount of substance of gallium (Ga) in the second region 3b, that is, the molar ratio represented by In/(In+Ga) in the second region 3b. With the above-mentioned configuration, a gradient is generated in the band gap of the light-absorbing layer 3, which moves the charges well and further enhances the photoelectric conversion efficiency in the photoelectric conversion device 10.

In this case, from the perspective of reducing the concentration of stress as a result of the stress being effectively alleviated, in the light-absorbing layer 3, the molar ratio represented by In/(In+Ga) may increase gradually or in steps from the first electrode layer 2 side to the buffer layer 4 side.

Methods 1 to 5 below are examples of the method of achieving a change in molar ratio represented by In/(In+Ga) in the light-absorbing layer 3 as described above. In Method 1, a precursor layer comprised of a plurality of layers, which have different compositions, is formed by application and drying of the stock solutions having different content ratios of Cu, In, Ga and Se, and then the precursor layer is heat-treated, to thereby form the light-absorbing layer 3. In Method 2, a precursor layer comprised of a plurality of layers, which have different compositions, is formed by application and drying of stock solutions having different content ratios of Cu, In and Ga, and then the precursor layer is heat-treated under an atmosphere containing Se vapors, to thereby form the light-absorbing layer 3. In Method 3, a precursor layer whose content ratio of Cu, In and Ga is varied gradually in the thickness direction is formed by sputtering or the like, and then the precursor layer is heat-treated under an atmosphere containing Se vapors, to thereby form the light-absorbing layer 3. In Method 4, CIGS is directly deposited while changing the composition by vapor deposition or the like, to thereby form the light-absorbing layer 3. In Method 5, a precursor having the content ratio of Cu, In, Ga and Se that is approximately uniform in the thickness direction is formed and, in a case where the Se content in the precursor does not satisfy the ratio of stoichiometric composition of CIGS, the light-absorbing layer 3 is formed by heat treatment under, for example, a reduction atmosphere. Note that it is possible to measure a change of the molar ratio represented by In/(In+Ga) in the light-absorbing layer 3 by, for example, energy dispersive X-ray spectrometry (EDX) with a scanning transmission electron microscope (STEM), that is, by analysis using STEM-EDX.

Further, as to the light-absorbing layer 3, the compound semiconductor constituting the light-absorbing layer 3 may contain Cu(In, Ga)(Se, S)₂. In this case, the ratio of an amount of substance (also referred to as molar ratio) represented by S/(Se+S) in the first region 3a may be smaller than the ratio of an amount of substance of sulfur (S) to the total of an amount of substance of selenium (Se) and an amount of substance of S in the second region 3b, that is, the molar ratio represented by S/(Se+S) in the second region 3b. With the above-mentioned configuration, a band gap of the light-absorbing layer 3 in the vicinity of the interface between the buffer layer 4 and the light-absorbing layer 3 becomes large, and a large voltage is extracted in the photoelectric conversion device 10.

In this case, from the perspective of reducing the concentration of stress as a result of the stress being effectively alleviated, in the light-absorbing layer 3, the molar ratio represented by S/(Se+S) may increase gradually or in steps from the first electrode layer 2 side to the buffer layer 4 side.

Methods i to iii below are examples of the method of achieving a change in the molar ratio represented by S/(Se+S) in the light-absorbing layer 3 as described above. In Method i, a precursor layer comprised of a plurality of layers having different compositions is formed by application and drying of stock solutions having different content ratios of Cu, In, Ga, Se and S, and the precursor layer is heat-treated, to thereby form the light-absorbing layer 3. In Method ii, CIGS is directly deposited while changing the composition by vapor deposition or the like, to thereby form the light-absorbing layer 3. In Method iii, a precursor layer having an approximately uniform composition in the thickness direction is formed by application and drying of a stock solution having an approximately uniform content ratio of Cu, In and Ga, and then the precursor layer is subjected to heat treatment under an atmosphere containing Se vapors and heat treatment under an atmosphere containing S vapors in order, to thereby form the light-absorbing layer 3. Note that in Method iii, Se is substituted by S during the heat treatment under an atmosphere containing S vapors, which increases the S content in the vicinity of the upper surface of the light-absorbing layer 3. Note that it is possible to measure a change of the molar ratio represented by S/(Se+S) in the light-absorbing layer 3 by, for example, analysis using STEM-EDS.

### <(2) Photoelectric conversion device according to Second Embodiment>

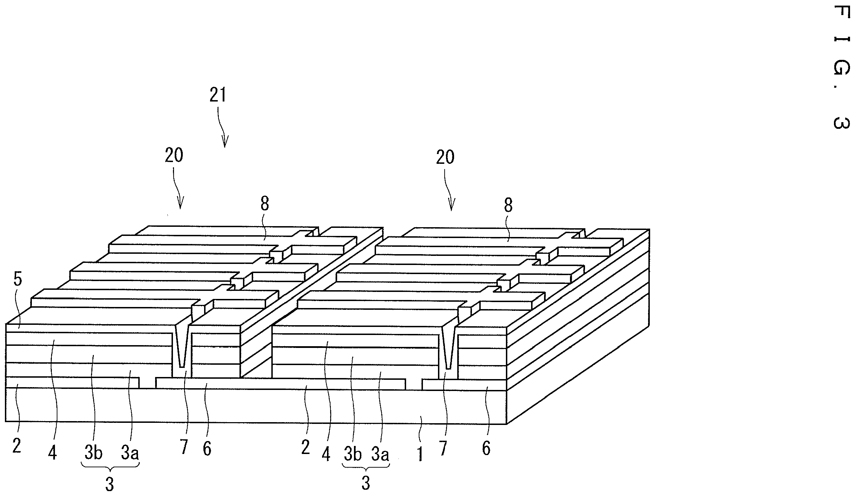

Next, a photoelectric conversion module 21 according to a second embodiment is described with reference to FIG. 2 and FIG. 3. FIG. 2 is a cross-sectional view of a photoelectric conversion device 20 according to the second embodiment, and FIG. 3 is a perspective view of the photoelectric conversion device 20. As shown in FIG. 2 and FIG. 3, the photoelectric conversion device 20 of the photoelectric conversion module 21 according to the second embodiment is different from the photoelectric conversion device 10 (FIG. 1) according to the first embodiment in that the collector electrode 8 is formed on the second electrode layer 5. In FIG. 2 and FIG. 3, ones having the same configurations as those of FIG. 1 are denoted by the same reference symbols. Similarly to the photoelectric conversion device 10 according to the first embodiment, the photoelectric conversion module 21 includes a plurality of photoelectric conversion devices 20 that are electrically connected. The collector electrode 8 is mainly comprised of a material excellent in conductivity, and serves to achieve a reduction in electrical resistance of the second electrode layer 5. From the perspective of enhancing light transmissivity, the thickness of the second electrode layer 5 can be reduced. In this case, when the collector electrode 8 is provided on the second electrode layer 5, the current generated in the light-absorbing layer 3 can be extracted efficiently while enhancing light transmissivity. This enhances the power generation efficiency of the photoelectric conversion device 20.

As shown in FIG. 3, for example, the collector electrode 8 is linearly formed from one end of the photoelectric conversion device 20 to the connection conductor 7. Accordingly, the charges generated by photoelectric conversion in the light-absorbing layer 3 are collected by the collector electrode 8 through the second electrode layer 5, and these charges are transmitted well to the neighboring photoelectric conversion device 20 through the connection conductor 7. This allows to efficiently extract the current generated in the light-absorbing layer 3 even when the second electrode layer 5 becomes slimmer due to the provision of the collector electrode 8. This enhances power generation efficiency.

From the perspective of reducing shielding of the light to the light-absorbing layer 3 to achieve conductivity well, the collector electrode 8 may have a width of 50 µm or more and 400 µm or less. Further, the collector electrode 8 may have a plurality of branch portions.

The collector electrode 8 is formed by, for example, pattern-printing a metal paste obtained by dispersing a powdered metal such as silver in a resin binder or the like, and curing this.

### <(3) Specific Examples>

### <(3-1) Method of preparing stock solution of CIGS>

First, phenylselenol that is an organic compound containing a chalcogen element was dissolved in aniline that is a Lewis base organic solvent to have a concentration of 100 mol%, whereby the mixed solvent S was prepared. Next, Cu of base metal, In of the base metal, Ga of the base metal and Se of the base metal were directly dissolved in the mixed solvent S, whereby the stock solution was prepared. In this stock solution, the Cu concentration was 2.3 wt%, In concentration was 3.2 wt%, Ga concentration was 1.3 wt%, and Se concentration was 7.2 wt%.

### <(3-2) Method of forming semiconductor layer in Example>

First, the resultant obtained by depositing the first electrode layer 2 containing Mo or the like onto the surface of the substrate 1 containing glass was prepared. Next, the stock solution was applied onto the first electrode layer 2 by a blade process under a nitrogen gas atmosphere and then dried, to thereby form a film as a precursor of the first region 3a. This film was held at 300°C for one hour and then was held at 560°C for one hour under a nitrogen gas atmosphere, thereby forming the first region 3a. After that, the stock solution was further applied onto the first region 3a by a blade process under a nitrogen gas atmosphere and then dried, whereby a film as a precursor of the second region 3b was formed on the first region 3a. This film was held at 560°C for one hour under a nitrogen gas atmosphere, whereby the second region 3b was formed. As a result, the light-absorbing layer 3 as a semiconductor layer mainly comprised of CIGS was formed. Note that in this case, the light-absorbing layer 3 of an approximately half the thickness thereof was considered to be as the first region 3a, while that of the other approximately half was considered to be as the second region 3b.

### <(3-3) Method of forming semiconductor layer in Comparative Example 1>

First, the resultant obtained by depositing the first electrode layer 2 containing Mo or the like onto the surface of the substrate 1 containing glass was prepared. Next, the stock solution was applied onto the first electrode layer 2 by a blade process under a nitrogen gas atmosphere and then dried, to thereby form a film as a precursor of the first region. This film was held at 560°C for one hour under a nitrogen gas atmosphere, thereby forming the first region. After that, the stock solution was applied onto the first region by a blade process under a nitrogen gas atmosphere and then dried, whereby a film as a precursor of the second region was formed on the first region. This film was held at 560°C for one hour under a nitrogen gas atmosphere, whereby the second region was formed. As a result, the light-absorbing layer as a semiconductor layer mainly comprised of CIGS was formed. Note that also in this case, the light-absorbing layer of an approximately half the thickness thereof was considered to be as the first region, while that of the other approximately half was considered to be as the second region.

### <(3-4) Method of forming semiconductor layer in Comparative Example 2>

First, the resultant obtained by depositing the first electrode layer 2 containing Mo or the like onto the surface of the substrate 1 containing glass was prepared. Next, the stock solution was applied onto the first electrode layer 2 by a blade process under a nitrogen gas atmosphere and then dried, to thereby form a film as a precursor of the first region. This film was held at 300°C for one hour and then was held at 560°C for one hour under a nitrogen gas atmosphere, thereby forming the first region. After that, the stock solution was applied onto the first region by a blade process under a nitrogen gas atmosphere and then dried, whereby a film as a precursor of the second region was formed on the first region. This film was held at 300°C for one hour and then held at 560°C for one hour under a nitrogen gas atmosphere, whereby the second region was formed. As a result, the light-absorbing layer as a semiconductor layer mainly comprised of CIGS was formed. Note that also in this case, the light-absorbing layer of an approximately half the thickness thereof was considered to be as the first region, while that of the other approximately half was considered to be as the second region.

### <(3-5) Method of manufacturing photoelectric conversion devices in Example and Comparative Examples 1 and 2>

The buffer layer 4 and the second electrode layer 5 were respectively formed in order on the light-absorbing layer formed as described above in Example and Comparative Examples 1 and 2, whereby the photoelectric conversion devices according to Example and Comparative Examples 1 and 2 were respectively manufactured.

Specifically, the substrate 1 in which the light-absorbing layer mainly comprised of CIGS had been formed was immersed in the solution obtained by dissolving cadmium acetate and thiourea in ammonia water, with the result that the buffer layer 4 including CdS and having a thickness of 50 nm was formed on the light-absorbing layer. Further, a transparent conductive film made of zinc oxide, which had been doped with A1, was formed on this buffer layer 4 by a sputtering method.

### <(3-6) Adhesion between first electrode layer and light-absorbing layer>

The adhesion between the first electrode layer 2 and the light-absorbing layer was evaluated by observation with a metallographic microscope for the photoelectric conversion devices according to Example and Comparative Examples 1 and 2. This observation with a metallographic microscope was performed after the formation of the light-absorbing layer on the first electrode layer 2 and before the formation of the buffer layer 4. Specifically, the first electrode 2 was exposed in the portion in which the light-absorbing layer had peeled off from the first electrode layer 2 containing Mo or the like and had been partially released (also referred to as peel portion), and thus the fact that the peel portion appears to be shinning white due to light reflection was used in the observation with a metallographic microscope from the upper surface side of the light-absorbing layer.

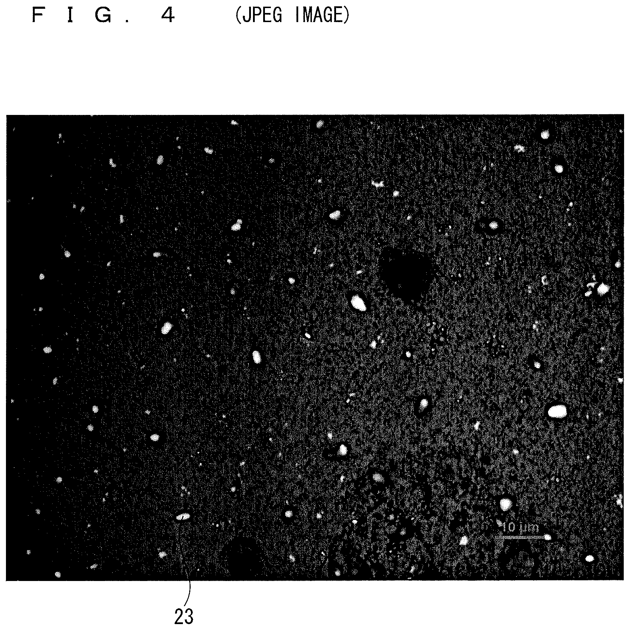

As a result of the observation with a metallographic microscope, one or more peel portions were found per 1 cm² in Comparative Example 1. FIG. 4 illustrates the peel-off state of the light-absorbing layer from the first electrode layer 2 in Comparative Example 1. As shown in FIG. 4, a large number of peel portions 23 were found. On the other hand, it was revealed in Example and Comparative Example 2 that any peel portion was not found and the adhesion between the first electrode layer 2 and the light-absorbing layer was excellent.

### <(3-7) Grain diameter of crystal grain in light-absorbing layer>

The average grain diameters of crystal grains of the first region and the second region in the light-absorbing layer were measured for the photoelectric conversion devices according to Example and Comparative Examples 1 and 2. The average grain diameters of crystal grains were measured by obtaining images (also referred to as cross-sectional images) of appropriate 10 spots, which were located evenly, in the cross sections of the first region and the second region by photographing with a scanning electron microscope (SEM), and then executing Steps (a1) to (a6) below in this order. (al) A transparent film was superimposed on a cross-sectional image and then grain boundaries were traced with a pen. On this occasion, a straight line (also referred to as a scale bar) indicating a predetermined distance (for example, 1 µm) shown in the vicinity of the corner of the cross-sectional image was also traced with a pen. (a2) The transparent film into which the grain boundaries and the scale bar had been written was read with a scanner, whereby image data was obtained. (a3) The area of the crystal grain was calculated from the image data obtained in Step (a2) with the use of given image processing soft. (a4) The average value of grain diameters of a plurality of crystal grains taken in one cross-sectional image was calculated. (a5) The average value of grain diameters of a plurality of crystal grains taken in ten cross-sectional images was calculated.

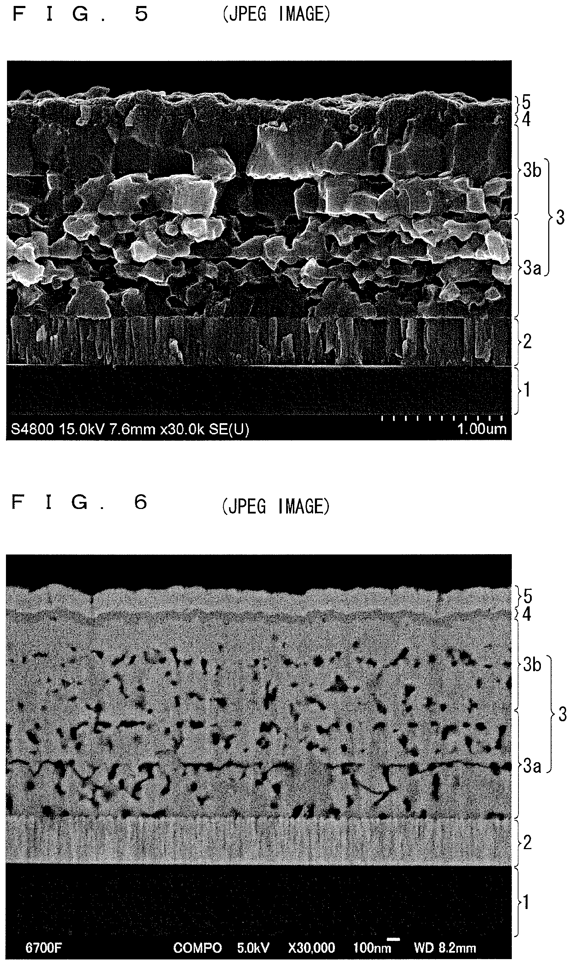

As a result of the measurement described above, in the light-absorbing layer 3 according to Example, the average grain diameter in the first region 3a was 0.2 µm, while the average grain diameter in the second region 3b was 1.0 µm. FIG. 5 illustrates the cross-sectional image obtained by photographing with a SEM for the cross section of the light-absorbing layer 3 according to Example. In FIG. 5, ones having the same configurations as those of FIG. 1 are denoted by the same reference symbols. While, in the light-absorbing layer according to Comparative Example 1, the average grain diameter in the first region was 1.0 µm, whereas the average grain diameter in the second region was 1.0 µm. Further, in the light-absorbing layer according to Comparative Example 2, the average grain diameter in the first region was 0.2 µm, while the average grain diameter in the second region was 0.2 µm.

FIG. 6 illustrates the image obtained by photographing with a metallographic microscope for the cross section of the light-absorbing layer 3 according to Example. In FIG. 6, ones having the same configurations as those of FIG. 1 are denoted by the same reference symbols, and the condition of voids in the light-absorbing layer 3 according to Example was taken. As shown in FIG. 6, it was confirmed that in the light-absorbing layer 3 according to Example, the void volume in the first region 3a was larger than the void volume in the second region 3b. The void volumes of the image shown in FIG. 6 were calculated with image processing soft, whereby the void volume of the first region 3a was 24%, while the void volume of the second region 3b was 6%.

### <(3-8) Conversion efficiency in photoelectric conversion device>

The conversion efficiency was measured with the use of a fixed light solar simulator for the photoelectric conversion devices according to Example and Comparative Examples 1 and 2. In this case, the conversion efficiency was measured on the conditions that the radiation intensity of the light to the light receiving surface of the photoelectric conversion device was 100 mW/cm² and the air mass (AM) was 1.5. Note that the conversion efficiency represents the ratio at which the energy of sunlight is converted into electrical energy in the photoelectric conversion device. In this case, it was derived by dividing the value of the electrical energy output from the photoelectric conversion device by the value of the energy of sunlight entering the photoelectric conversion device and then multiplying the resultant value by 100.

As a result of the conversion efficiency measurement, the conversion efficiency in Comparative Example 1 was 4%, while the conversion efficiency in Comparative Example 2 was 4%. In contrast to these, the conversion efficiency in Example was 12%, which was an excellent value.

### <(3-9) Summary of specific examples>

The light-absorbing layer 3 was resistant to peel-off from the first electrode layer 2 and excellent conversion efficiency was obtained when the average grain diameter in the first region 3a was smaller than the average grain diameter in the second region 3b as in the photoelectric conversion device according to Example. That is, it was found that the photoelectric conversion device 10, 20, which has high adhesion between the light-absorbing layer 3 and the first electrode layer 2 as well as high photoelectric conversion efficiency, is achieved.

### <(4) Others>

The present invention is not limited to the above-described embodiments, and various modifications can be made without departing from the essence of the present invention.

For example, the first and third electrode layers 2 and 6, light-absorbing layer 3, buffer layer 4 and second electrode layer 5 are layered in this order in the first and second embodiments, which is not limited thereto. For example, the configuration in which the buffer layer 4 is not provided is also feasible. Note that from the perspective of securing high photoelectric conversion efficiency, the buffer layer 4 may be provided. Alternatively, for example, the other layer may be interposed between the first and third electrode layers 2 and 6 and the light-absorbing layer 3. Examples of the other layer include a selenium compound of Mo (such as MoSe₂) in a case where the first and third electrode layers 2 and 6 mainly contain Mo. Further, for example, in a case where the light-absorbing layer 3 is mainly comprised of CIGS, a layer containing GIGSS having a composition different from that of CIGS may be interposed between the light-absorbing layer 3 and the buffer layer 4. Accordingly, it suffices that the photoelectric conversion device includes at least a first layer including the first electrode layer 2 and a second layer that is provided on the first layer and includes the light-absorbing layer 3. Further, from the perspective of securing photoelectric conversion efficiency, a third layer including the buffer layer 4 may be provided on the second layer.

### Description of Symbols

- 1: substrate
- 2: first electrode layer
- 3: light-absorbing layer
- 3a: first region
- 3b: second region
- 4: buffer layer
- 5: second electrode layer
- 6: third electrode layer
- 7: connection conductor
- 8: collector electrode
- 10, 20: photoelectric conversion device
- 11, 21: photoelectric conversion module

## Claims

1. A photoelectric conversion device (10; 20) comprising a first layer and a second layer located on the first layer, wherein:
the first layer comprises an electrode layer (2);
the second layer comprises a light-absorbing layer (3) comprising a group I-III-VI compound semiconductor;
the light-absorbing layer (3) comprises a first region (3a) and a second region (3b) located farther from the first layer than the first region (3a); and
an average grain diameter of crystal grains in the second region (3b) is larger than an average grain diameter of crystal grains in the first region (3a),
**characterized in that**
voids are present in at least the first region (3a) amongst the first region (3a) and the second region (3b), and
a void volume in the first region (3a) is larger than a void volume in the second region (3b).

2. The photoelectric conversion device (10; 20) according to Claim 1, wherein a third layer is located on the second layer, the third layer comprising a semiconductor layer (4) of a conductivity type different from a conductivity type of the light-absorbing layer (3).

3. The photoelectric conversion device (10; 20) according to Claim 1, wherein in the light-absorbing layer (3), the average grain diameter shows a tendency to increase gradually or in steps as a distance increases away from the first layer.

4. The photoelectric conversion device (10; 20) according to Claim 1, wherein:
group III-B elements of the group I-III-VI compound semiconductor comprise indium and gallium; and
a ratio of an amount of substance of indium to a total amount of substances of indium and gallium in the first region (3a) is smaller than a ratio of an amount of substance of indium to a total amount of substances of indium and gallium in the second region (3b).

5. The photoelectric conversion device (10; 20) according to Claim 4, wherein in the light-absorbing layer (3), the ratio of an amount of substance of indium to a total amount of substances of indium and gallium shows a tendency to increase gradually or in steps as a distance increases away from the first layer.

6. The photoelectric conversion device (10; 20) according to Claim 1, wherein:
group VI-B elements of the group I-III-VI compound semiconductor comprise selenium and sulfur; and
a ratio of an amount of substance of sulfur to a total amount of substances of selenium and sulfur in the first region (3a) is smaller than a ratio of an amount of substance of sulfur to a total amount of substances of selenium and sulfur in the second region (3b).

7. The photoelectric conversion device (10; 20) according to Claim 6, wherein in the light-absorbing layer (3), the ratio of an amount of substance of sulfur to the total amount of substances of selenium and sulfur shows a tendency to increase gradually or in steps as a distance increases away from the first layer.

## Patentansprüche

1. Eine fotoelektrische Umwandlungsvorrichtung (10, 20), aufweisend eine erste Schicht und eine zweite Schicht, die auf der ersten Schicht angeordnet ist, wobei
die erste Schicht eine Elektrodenschicht (2) aufweist,
die zweite Schicht eine lichtabsorbierende Schicht (3) aufweist, die einen Gruppe- I-III-VI -Verbindungshalbleiter aufweist,
die lichtabsorbierende Schicht (3) einen ersten Bereich (3a) und einen zweiten Bereich (3b) aufweist, der von der ersten Schicht weiter entfernt angeordnet ist als der erste Bereich (3a), und
ein durchschnittlicher Korndurchmesser von Kristallkörnern im zweiten Bereich (3b) größer als ein durchschnittlicher Korndurchmesser von Kristallkörnern im ersten Bereich (3a) ist,
**dadurch gekennzeichnet, dass**
Lücken sich mindestens im ersten Bereich (3a) von dem ersten Bereich (3a) und dem zweiten Bereich (3b) befinden, und
ein Lückenvolumen im ersten Bereich (3a) größer als ein Lückenvolumen im zweiten Bereich (3b) ist.

2. Die fotoelektrische Umwandlungsvorrichtung (10, 20) gemäß Anspruch 1, wobei eine dritte Schicht auf der zweiten Schicht angeordnet ist, wobei die dritte Schicht eine Halbleiterschicht (4) eines Leitfähigkeitstyps aufweist, der sich von einem Leitfähigkeitstyp der lichtabsorbierenden Schicht (3) unterscheidet.

3. Die fotoelektrische Umwandlungsvorrichtung (10, 20) gemäß Anspruch 1, wobei in der lichtabsorbierenden Schicht (3) der durchschnittliche Korndurchmesser eine Neigung dazu hat, allmählich oder in Stufen größer zu werden, während ein Abstand von der ersten Schicht größer wird.

4. Die fotoelektrische Umwandlungsvorrichtung (10, 20) gemäß Anspruch 1, wobei:
Gruppe- III-B -Elemente des Gruppe- I-III-VI -Verbindungshalbleiters Indium und Gallium aufweisen und
ein Verhältnis einer Stoffmenge von Indium zu einer Gesamtstoffmenge von Indium und Gallium im ersten Bereich (3a) kleiner als ein Verhältnis einer Stoffmenge von Indium zu einer Gesamtstoffmenge von Indium und Gallium im zweiten Bereich (3b) ist.

5. Die fotoelektrische Umwandlungsvorrichtung (10, 20) gemäß Anspruch 4, wobei in der lichtabsorbierenden Schicht (3) das Verhältnis einer Stoffmenge von Indium zu einer Gesamtstoffmenge von Indium und Gallium eine Neigung dazu hat, allmählich oder in Stufen größer zu werden, während der Abstand von der ersten Schicht größer wird.

6. Die fotoelektrische Umwandlungsvorrichtung (10, 20) gemäß Anspruch 1, wobei:
Gruppe- VI-B -Elemente des Gruppe- I-III-VI -Verbindungshalbleiters Selen und Schwefel aufweisen und
ein Verhältnis einer Stoffmenge von Schwefel zu einer Gesamtstoffmenge von Selen und Schwefel im ersten Bereich (3a) kleiner als ein Verhältnis einer Stoffmenge von Schwefel zu einer Gesamtstoffmenge von Selen und Schwefel im zweiten Bereich (3b) ist.

7. Die fotoelektrische Umwandlungsvorrichtung (10, 20) gemäß Anspruch 6, wobei in der lichtabsorbierenden Schicht (3) das Verhältnis einer Stoffmenge von Schwefel zu der Gesamtstoffmenge von Selen und Schwefel eine Neigung dazu hat, allmählich oder in Stufen größer zu werden, während ein Abstand von der ersten Schicht größer wird.

## Revendications

1. Un dispositif de conversion photoélectrique (10, 20), comportant une première couche et une deuxième couche située sur la première couche, dans lequel :
la première couche comprend une couche d'électrode (2),
la deuxième couche comprend une couche absorbant la lumière (3) comprenant un semi-conducteur composé de groupe I-III-VI,
la couche absorbant la lumière (3) comprend une première région (3a) et une deuxième région (3b) située plus éloignée de la première couche que la première région (3a), et
un diamètre de grain moyen de grains de cristal dans la deuxième région (3b) est supérieur à un diamètre de grain moyen de grains de cristal dans la première région (3a),
**caractérisé en ce que**
des vides sont présents dans au moins la première région (3a) parmi la première région (3a) et la deuxième région (3b), et
un volume de vide dans la première région (3a) est supérieur à un volume de vide dans la deuxième région (3b).

2. Le dispositif de conversion photoélectrique (10, 20) selon la revendication 1, dans lequel une troisième couche est située sur la deuxième couche, la troisième couche comportant une couche semi-conductrice (4) d'un type de conductivité qui est différent d'un type de conductivité de la couche absorbant la lumière (3).

3. Le dispositif de conversion photoélectrique (10, 20) selon la revendication 1, dans lequel, dans la couche absorbant la lumière (3), le diamètre de grain moyen a une tendance à augmenter progressivement ou en étapes alors qu'une distance de la première couche augmente.

4. Le dispositif de conversion photoélectrique (10, 20) selon la revendication 1, dans lequel :
des éléments de groupe III-B du semi-conducteur composé de groupe I-III-VI comprennent de l'indium et du gallium, et
un rapport d'une quantité de substance d'indium à une quantité totale de substances d'indium et de gallium dans la première région (3a) est inférieur à un rapport d'une quantité de substance d'indium à une quantité totale de substances d'indium et de gallium dans la deuxième région (3b) .

5. Le dispositif de conversion photoélectrique (10, 20) selon la revendication 4, dans lequel, dans la couche absorbant la lumière (3), le rapport d'une quantité de substance d'indium à une quantité totale de substances d'indium et de gallium a une tendance à augmenter progressivement ou en étapes alors qu'une distance de la première couche augmente.

6. Le dispositif de conversion photoélectrique (10, 20) selon la revendication 1, dans lequel :
des éléments de groupe VI-B du semi-conducteur composé de groupe I-III-VI comprennent du sélénium et du soufre, et
un rapport d'une quantité de substance de soufre à une quantité totale de substances de sélénium et de soufre dans la première région (3a) est inférieur à un rapport d'une quantité de substance de soufre à une quantité totale de substances de sélénium et de soufre dans la deuxième région (3b) .

7. Le dispositif de conversion photoélectrique (10, 20) selon la revendication 6, dans lequel, dans la couche absorbant la lumière (3), le rapport d'une quantité de substance de soufre à la quantité totale de substances de sélénium et de soufre a une tendance à augmenter progressivement ou en étapes alors qu'une distance de la première couche augmente.
